# EUROPEAN PATENT APPLICATION

(11) **EP 4 734 707 A1**
(43) Date of publication of application: **29.04.2026**
(21) Application number: 25164766.5
(22) Date of filing: 19.03.2025
(51) Int. Cl.: H10F 30/223, H10F 77/14, H10F 77/30

(54) **PHOTODIODE AND MANUFACTURING METHOD THEREOF**

(30) Priority: 25.10.2024 TW 113140907
(71) Applicant: Taiwan-Asia Semiconductor Corporation, Hsinchu City 30078 (TW)
(72) Inventor: Lin, Chun-Chieh, 30078 Hsinchu City (TW); Yang, Zhi-Wei, 30078 Hsinchu City (TW); Kuo, Yuan-Kun, 30078 Hsinchu City (TW); Tseng, Pao-Yi, 30078 Hsinchu City (TW)
(74) Representative: Michalski Hüttermann & Partner Patentanwälte mbB

(57) **Abstract**

A photodiode and a manufacturing method thereof are provided. The photodiode (100) comprises a first conductive type semiconductor layer (110), an intrinsic layer (120), a second conductive type semiconductor layer (130) and an upper edge bevel (150). The intrinsic layer (120) s disposed on the first conductive type semiconductor layer (110), and the second conductive type semiconductor layer (130) is disposed on a central region of the intrinsic layer (120) and exposes a peripheral region of the intrinsic layer surrounding the central region. The upper edge bevel (150) is disposed at an edge of the peripheral region of the intrinsic layer (120) so that a first angle between a horizontal line and a first external light entering the intrinsic layer through the upper edge bevel is larger than a second angle between the horizontal line and a second external light entering the intrinsic layer without passing through the upper edge bevel.

## Description

### CROSS-REFERENCES TO RELATED APPLICATIONS

This application claims the benefit of priority to Taiwanese Patent Application No. 113140907 filed on October 25, 2024, which is hereby incorporated by reference in its entirety.

### BACKGROUND OF THE INVENTION

### Field of the Invention

The present invention relates to a photodiode and a manufacturing method thereof, and in particular to a photodiode with high linearity for photodetection and a manufacturing method thereof.

### Descriptions of the Related Art

A photodiode is an electronic device designed to convert external optical signals into electrical signals. The core function of a photodiode lies in its ability to absorb external light for enabling the detection of optical signals and their conversion into measurable current. This conversion is critical for various applications, such as optical communication, optical measurement, and image generation.

The mechanism by which photodiodes absorb external light relies on the semiconductor material within the diode (e.g., silicon substrate). When photons enter the photodiode and are absorbed, their energy excites electrons in the valence band to transition to the conduction band for generating electron-hole pairs. These photogenerated carriers are separated under the influence of the diode's built-in electric field and an electric current is generated correspondingly.

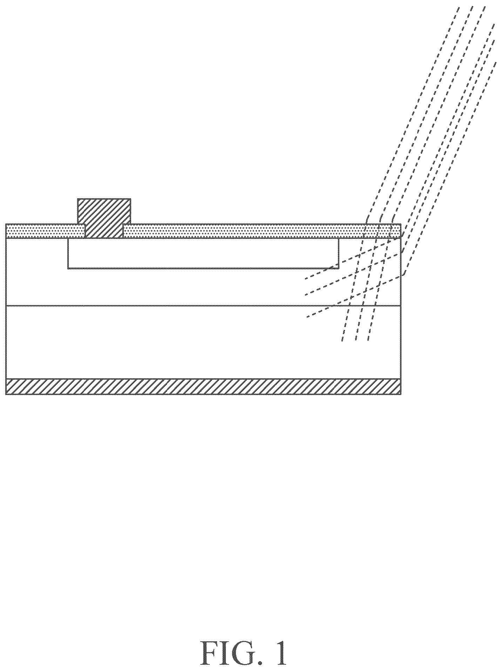

However, in practical applications of traditional photodiodes, external light can easily penetrate the exposed sidewalls of the device and lead to interference in internal operations. This interference degrades the linearity of the photodetector's performance and introduces computational errors in subsequent applications. As shown in FIG. 1, external light penetrating the exposed sidewalls of a conventional photodiode is concentrated at the edges of the device due to the refractive index (3.4) of the silicon substrate, which is significantly higher than the refractive index (1) of air. This phenomenon further affects the detection linearity of the photodiode.

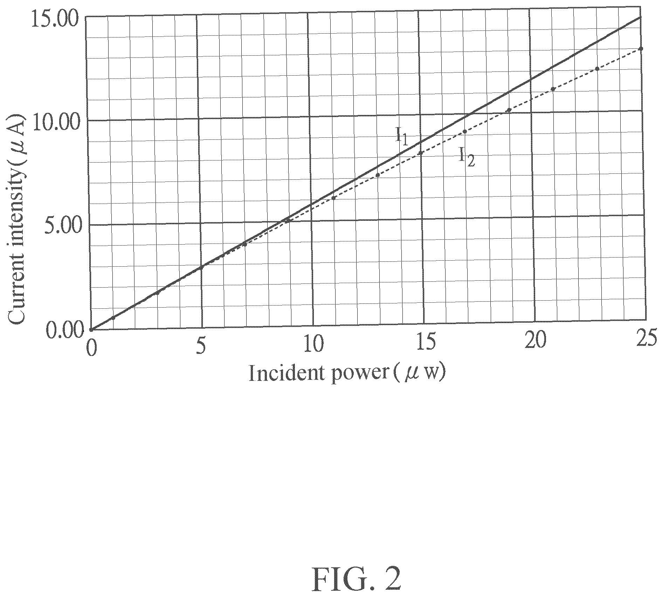

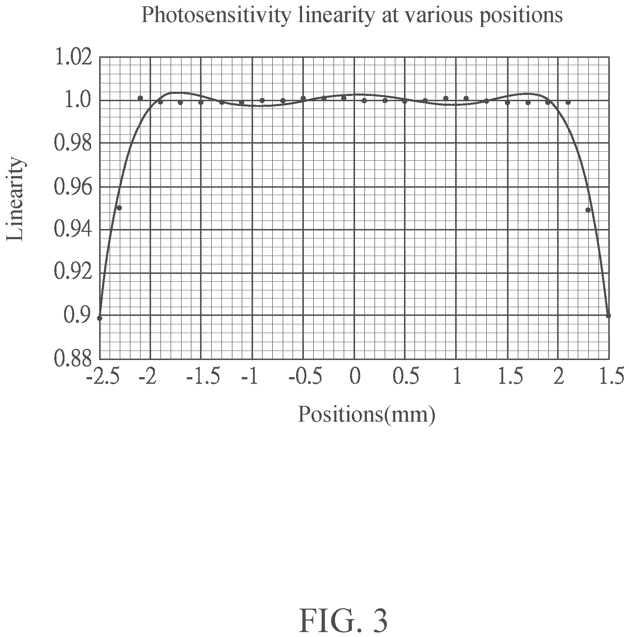

As illustrated in FIG. 2, line I₁ represents the photodiode's ideal linearity, wherein the current intensity generated by the photodiode maintains a linear relationship with the increasing power of incident external light. Conversely, line I₂ represents the actual linearity between the incident light power and the corresponding current intensity under practical operating conditions. As shown in FIG. 2, as the incident power increases, the intensity of the electrical signal generated by the photodiode cannot maintain a linear growth relationship and exhibits a certain degree of attenuation. Additionally, as shown in FIG. 3, analyzing the linearity of the sensitivity across various positions within the photodiode reveals a stark contrast: the central region maintains high consistency in the linearity of its sensitivity, while the edge region experiences a sharp decline. To address these issues, there is an urgent need for an innovative photodiode structure to resolve the problem of inadequate linearity for its sensitivity caused by external light penetrating the device's sidewalls.

### SUMMARY OF THE INVENTION

The main objective of the present invention is to provide an innovative photodiode and its manufacturing method. Compared to conventional photodetection devices, the photodiode of the present invention features an upper edge bevel at the edge of its sidewall. This design reduces the concentration of external light entering the device for thereby improving the linearity of photodiode's sensitivity and mitigating issues such as erroneous signals resulting from insufficient linearity.

To achieve the above objective, the present invention discloses a photodiode comprises a first conductive type semiconductor layer, an intrinsic layer, a second conductive type semiconductor layer and an upper edge bevel. The intrinsic layer is disposed on the first conductive type semiconductor layer, and the second conductive type semiconductor layer is disposed on a central region of the intrinsic layer and exposes a peripheral region of the intrinsic layer surrounding the central region. The upper edge bevel is disposed at an edge of the peripheral region of the intrinsic layer so that a first angle between a horizontal line and a first external light entering the intrinsic layer through the upper edge bevel is larger than a second angle between the horizontal line and a second external light entering the intrinsic layer without passing through the upper edge bevel.

In one embodiment of a photodiode of the present invention, the upper edge bevel is one of a concave angle, a bevel angle and a convex angle.

In one embodiment of a photodiode of the present invention, a depth of the upper edge bevel to an upper surface of the intrinsic layer is approximately 5 to 15 micrometers (µm).

In one embodiment of a photodiode of the present invention, the photodiode further comprises a metal layer covering the upper edge bevel and the peripheral region of the intrinsic layer.

In one embodiment of a photodiode of the present invention, the material of the metal layer is selected from a group consisting of aluminum (Al), titanium (Ti), nickel (Ni), and gold (Au).

In one embodiment of a photodiode of the present invention, a thickness of the intrinsic layer is approximately 50 to 70 micrometers (µm).

In one embodiment of a photodiode of the present invention, the intrinsic layer is an N-type lightly doped silicon layer with phosphorus as dopants at a doping concentration of 10¹²~10¹³ cm⁻³.

To achieve the above objective, the present invention discloses a manufacturing method of a photodiode comprising the following steps: providing a first conductive type semiconductor layer, providing an intrinsic layer disposed on the first conductive type semiconductor layer, providing a second conductive type semiconductor layer disposed on a central region of the intrinsic layer and exposing a peripheral region of the intrinsic layer surrounding the central region, and providing an upper edge bevel disposed at an edge of the peripheral region of the intrinsic layer so that a first angle between a horizontal line and a first external light entering the intrinsic layer through the upper edge bevel is larger than a second angle between the horizontal line and a second external light entering the intrinsic layer without passing through the upper edge bevel.

In one embodiment of a method of manufacturing a photodiode of the present invention, the step of providing an upper edge bevel is to provide one of a concave angle, a bevel angle and a convex angle.

In one embodiment of a method of manufacturing a photodiode of the present invention, the step of providing an upper edge bevel is to isotropically etch the edge of the peripheral region of the intrinsic layer to form a depth of approximately 5 to 15 micrometers (µm) of the upper edge bevel to an upper surface of the intrinsic layer.

In one embodiment of a method of manufacturing a photodiode of the present invention, the method further comprises a step of providing a metal layer covering the upper edge bevel and the peripheral region of the intrinsic layer.

In one embodiment of a method of manufacturing a photodiode of the present invention, the step of providing the metal layer is a step of providing the material thereof is selected from a group consisting of aluminum (Al), titanium (Ti), nickel (Ni), and gold (Au).

In one embodiment of a method of manufacturing a photodiode of the present invention, the step of providing the intrinsic layer is to provide a thickness of approximately 50 to 70 micrometers (µm) of an N- type lightly doped silicon layer with phosphorus as dopants at a doping concentration of 10¹²~10¹³ cm⁻³.

After referring to the drawings and the embodiments as described in the following, those the ordinary skilled in this art can understand other objectives of the present invention, as well as the technical means and embodiments of the present invention.

### BRIEF DESCRIPTION OF THE DRAWINGS

FIG. 1 illustrates a schematic diagram of external light being focused as it enters the structure of a conventional photodiode.
FIG. 2 illustrates a schematic diagram of the linearity of sensitivity in a conventional photodiode under ideal conditions and actual operation.
FIG. 3 illustrates a schematic diagram of the sensitivity linearity at various locations inside a conventional photodiode.
FIG. 4A illustrates a schematic diagram of a photodiode in an embodiment of the present invention.
FIG. 4B illustrates a schematic diagram of external light entering the interior of the photodiode in an embodiment of the present invention.
FIG. 5 illustrates a comparative schematic diagram of the same external light entering the photodiode in an embodiment of the present invention and a conventional photodiode.
FIG. 6 illustrates a schematic diagram of a photodiode in another embodiment of the present invention.
FIG. 7 illustrates a schematic diagram of the process steps for manufacturing the photodiode in an embodiment of the present invention.

### DETAILED DESCRIPTION OF THE PREFERRED EMBODIMENT

In the following description, the present invention will be explained with reference to various embodiments thereof. These embodiments of the present invention are not intended to limit the present invention to any specific environment, application or particular method for implementations described in these embodiments. Therefore, the description of these embodiments is for illustrative purposes only and is not intended to limit the present invention. It shall be appreciated that, in the following embodiments and the attached drawings, a part of elements not directly related to the present invention may be omitted from the illustration, and dimensional proportions among individual elements and the numbers of each element in the accompanying drawings are provided only for ease of understanding but not to limit the present invention.

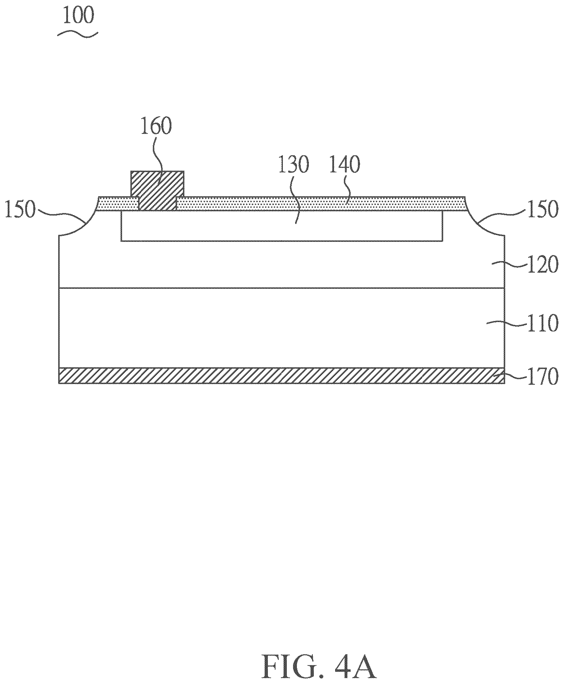

Refer to FIG. 4A, which illustrates a schematic diagram of a photodiode in one embodiment of the present invention. In this embodiment, the photodiode 100 comprises a first conductive type semiconductor layer 110, an intrinsic layer 120, a second conductive type semiconductor layer 130, a protective layer 140, an upper edge bevel 150, an upper electrode 160, and a lower electrode 170. The first conductive type semiconductor layer 110 is a heavily doped N-type semiconductor layer, such as, but not limited to an antimony (Sb)-doped silicon wafer with a doping concentration of approximately 10¹⁸~10¹⁹ cm⁻³. The intrinsic layer 120 is a lightly doped semiconductor layer disposed on the first conductive type semiconductor layer 110, such as, but not limited to an N-type lightly doped epitaxial silicon layer doped with phosphorus (P) at a concentration of 10¹²~10¹³ cm⁻³. This layer is designed to generate an electrical signal in response to light of a specific wavelength. The thickness of the intrinsic layer 120 is typically tailored to the wavelength and application requirements of the light, as it is crucial for optimizing photoelectric conversion efficiency. In the present invention, the intrinsic layer 120 has a thickness of approximately 50 to 70 micrometers (µm), but not limited thereto.

As shown in FIG. 4A, the second conductivity-type semiconductor layer 130 is disposed on a central region of the intrinsic layer 120, leaving an outer peripheral region of the intrinsic layer 120 exposed. The second conductivity-type semiconductor layer 130 is a P-type doped semiconductor layer, such as, but not limited to a boron (B)-doped silicon layer with a doping concentration of 10¹⁹-10²⁰ cm⁻³. The protective layer 140 typically functions as a band-pass filter covering the second conductivity type semiconductor layer 130 for selectively allowing light of a specific wavelength to pass through and be absorbed by the intrinsic layer 120, while blocking other wavelengths, such as visible or infrared light. The protective layer 140 is usually composed of stacked dielectric materials with alternating high and low refractive indices, such as silicon dioxide (SiO₂), titanium dioxide (TiO₂), or silicon nitride (Si₃N₄). In a preferred embodiment, the protective layer 140 further includes an anti-reflection layer formed on the band-pass filter layer, which enhances the transmittance of specific wavelengths of light, improves photon utilization, and minimizes reflection losses of incident light for thereby increasing the photoelectric conversion efficiency of the device. Meanwhile, the upper electrode 160, acting as the anode, is disposed on and electrically connected to the second conductivity-type semiconductor layer 130, while the lower electrode 170, acting as the cathode, is disposed on the back side of the first conductivity type semiconductor layer 110 and electrically connected to it. Both the upper electrode 160 and the lower electrode 170 are made of, but are not limited to, aluminum metal.

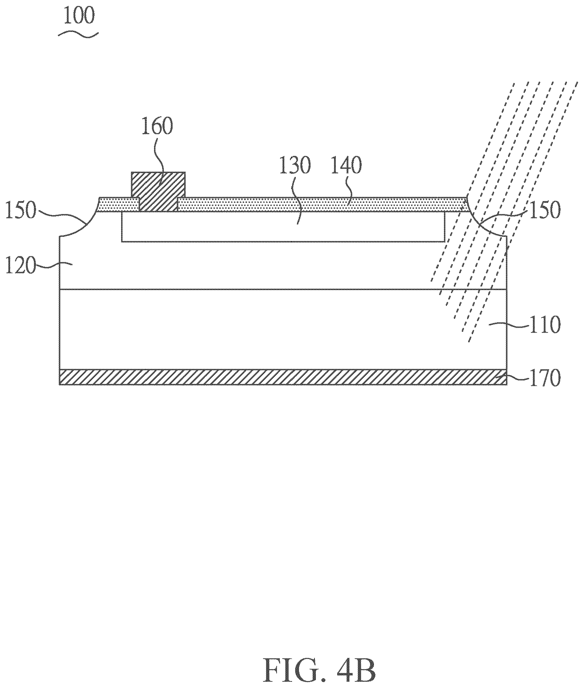

To address the issue of poor linearity in conventional photodiodes, the photodiode 100 of the present invention is designed with an upper edge bevel 150 on the structure's upper edge. Refer to FIG. 4A and FIG. 4B. Specifically, the upper edge bevel 150 is configured to be disposed at the edge of the peripheral region of the intrinsic layer 120. The upper edge bevel 150 may take various forms, such as, but not limited to a concave bevel, an inclined bevel, or even a convex bevel. For instance, the upper edge bevel 150 is formed using isotropic etching at the edge of the peripheral region of the intrinsic layer 120 for creating an inclined or concave structure with a depth of approximately 5 to 15 micrometers (µm) from the surface of the intrinsic layer. The purpose of the upper edge bevel in the present invention is to diffuse and reduce the concentration of external light entering the intrinsic layer through the sidewalls for thereby improving the linearity of the device's sensitivity. Compared to FIG. 1, FIG. 4B demonstrates that external light entering the photodiode 100 of the present invention undergoes a significant scattering effect after interacting with the upper edge bevel 150 for resulting in light rays deflected more vertically. This feature improves the sensitivity linearity of the photodiode.

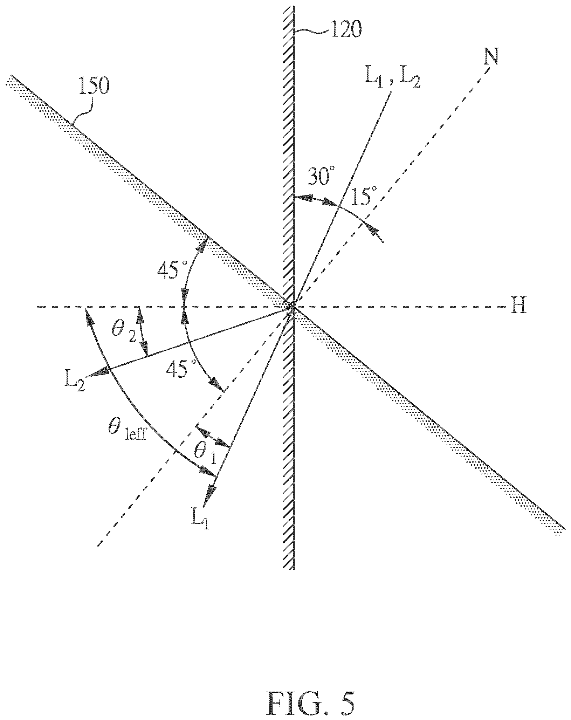

An example is provided below to illustrate how the upper edge bevel of the photodiode in the present invention reduces the concentration of light entering the device. Refer to FIG. 5. First, note that in FIG. 5, the component 120 represents the edge portion of the intrinsic layer 120 without an upper edge bevel, characterized by vertical sidewalls. On the other hand, the component 150 represents the portion of the upper edge bevel 150 formed as inclined sidewalls at the edge of the peripheral region of the intrinsic layer 120. As shown in FIG. 5, when the first external light ray L₁ enters the inclined sidewall of the upper edge bevel 150 at an angle of 15° with respect to the normal N (i.e., the angle between L₁ and the inclined sidewall is 75°), Snell's Law can be applied. Given that the refractive index of air is 1 and that of the silicon material of the intrinsic layer 120 is 3.4, the refraction angle θ₁ of the first external light ray L₁ inside the intrinsic layer 120 can be calculated as approximately 4.4°. This results in a horizontal angle θ_{1eff} of approximately 49.4° between L₁ and the horizontal line H. Comparatively, when a second external light ray L₂ enters the vertical sidewall of the intrinsic layer 120 without the upper edge bevel at the same incident angle, its refraction angle θ₂ is approximately 14.8°. Hence, the horizontal angle θ_{1eff} (49.4°) is significantly greater than θ₂ (14.8°). It is evident that the photodiode with the upper edge bevel effectively deflects external light entering the device "outward," i.e., away from the central region of the device. Thereby, the upper edge bevel of the photodiode of the present invention effects to reduce light concentration and improve the sensitivity linearity thereof.

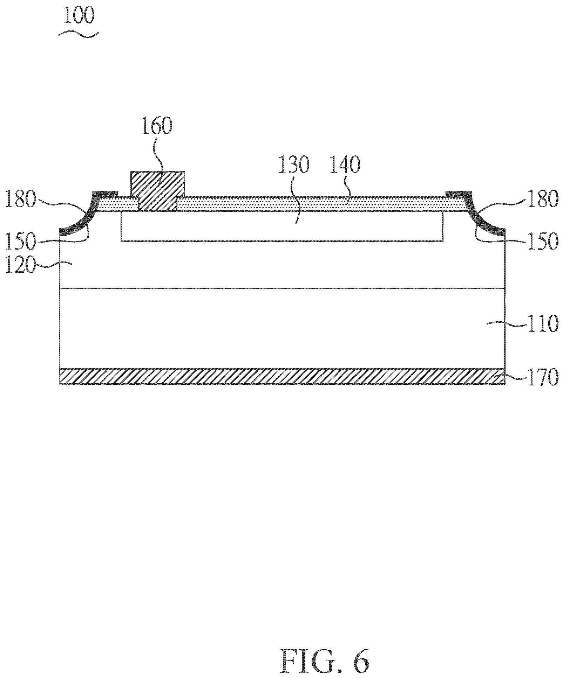

Refer to FIG. 6, which shows another embodiment of the photodiode 100. Unlike the previous embodiment, this photodiode 100 includes an additional metal layer 180 covering the upper edge bevel 150 and a portion of the protective layer 140 where is outside the second conductivity type semiconductor layer 130 and on the peripheral region of the intrinsic layer 120. The metal layer 180 is formed through a metal deposition process and is composed of a material selected from a group consisting of aluminum (Al), titanium (Ti), nickel (Ni), and gold (Au). This metal layer reflects or absorbs external light at these locations for preventing it from entering the device and affecting the sensitivity linearity of the device.

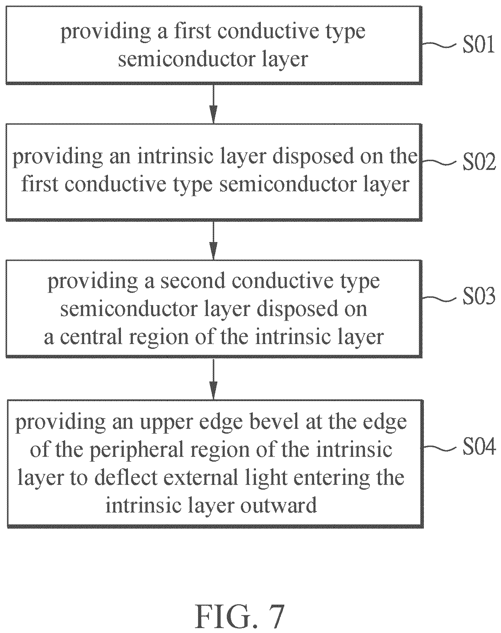

Refer to FIG. 7, which illustrates the process steps for manufacturing the photodiode of the present invention. First, in step S01, a first conductivity type semiconductor layer is provided. Next, in step S02, an intrinsic layer is provided and disposed on the first conductivity type semiconductor layer. In step S03, a second conductivity type semiconductor layer is provided and disposed on the central region of the intrinsic layer, leaving the peripheral region of the intrinsic layer exposed. Finally, in step S04, an upper edge bevel is provided at the edge of the peripheral region of the intrinsic layer to deflect external light entering the intrinsic layer outward. Specifically, the horizontal angle of the first external light entering the intrinsic layer through the upper edge bevel is greater than that of the second external light entering the intrinsic layer without the upper edge bevel. The detailed descriptions of the components are as mentioned above and will not be repeated here.

The above embodiments are used only to illustrate the implementations of the present invention and to explain the technical features of the present invention, and are not used to limit the scope of the present invention. Any modifications or equivalent arrangements that can be easily accomplished by people skilled in the art are considered to fall within the scope of the present invention, and the scope of the present invention should be limited by the claims of the patent application.

## Claims

1. A photodiode, comprising:
a first conductive type semiconductor layer;
an intrinsic layer, disposed on the first conductive type semiconductor layer;
a second conductive type semiconductor layer, disposed on a central region of the intrinsic layer and exposing a peripheral region of the intrinsic layer surrounding the central region; and
an upper edge bevel, disposed at an edge of the peripheral region of the intrinsic layer so that a first angle between a horizontal line and a first external light entering the intrinsic layer through the upper edge bevel is larger than a second angle between the horizontal line and a second external light entering the intrinsic layer without passing through the upper edge bevel.

2. The photodiode of claim 1, wherein the upper edge bevel is one of a concave angle, a bevel angle and a convex angle.

3. The photodiode of claim 1, wherein a depth of the upper edge bevel to an upper surface of the intrinsic layer is approximately 5 to 15 micrometers (µm).

4. The photodiode of claim 1, further comprising a metal layer covering the upper edge bevel and the peripheral region of the intrinsic layer.

5. The photodiode of claim 4, wherein the material of the metal layer is selected from a group consisting of aluminum (Al), titanium (Ti), nickel (Ni), and gold (Au).

6. The photodiode of claim 1, wherein a thickness of the intrinsic layer is approximately 50 to 70 micrometers (µm).

7. The photodiode of claim 1, wherein the intrinsic layer is an N-type lightly doped silicon layer with phosphorus as dopants at a doping concentration of 10¹²~10¹³ cm⁻³.

8. A manufacturing method of a photodiode, comprising:
providing a first conductive type semiconductor layer;
providing an intrinsic layer, disposed on the first conductive type semiconductor layer;
providing a second conductive type semiconductor layer, disposed on a central region of the intrinsic layer and exposing a peripheral region of the intrinsic layer surrounding the central region; and
providing an upper edge bevel, disposed at an edge of the peripheral region of the intrinsic layer so that a first angle between a horizontal line and a first external light entering the intrinsic layer through the upper edge bevel is larger than a second angle between the horizontal line and a second external light entering the intrinsic layer without passing through the upper edge bevel.

9. The manufacturing method of a photodiode of claim 8, wherein the step of providing an upper edge bevel is to provide one of a concave angle, a bevel angle and a convex angle.

10. The manufacturing method of a photodiode of claim 8, wherein the step of providing an upper edge bevel is to isotropically etch the edge of the peripheral region of the intrinsic layer to form a depth of approximately 5 to 15 micrometers (µm) of the upper edge bevel to an upper surface of the intrinsic layer.

11. The manufacturing method of a photodiode of claim 8, further comprising a step of providing a metal layer covering the upper edge bevel and the peripheral region of the intrinsic layer.

12. The manufacturing method of a photodiode of claim 11, wherein the step of providing the metal layer is a step of providing the material thereof is selected from a group consisting of aluminum (Al), titanium (Ti), nickel (Ni), and gold (Au).

13. The manufacturing method of a photodiode of claim 8, wherein the step of providing the intrinsic layer is to provide a thickness of approximately 50 to 70 micrometers (µm) of an N- type lightly doped silicon layer with phosphorus as dopants at a doping concentration of 10¹²~10¹³ cm⁻³.
